# EUROPEAN PATENT APPLICATION

(11) **EP 1 853 099 A1**
(43) Date of publication of application: **07.11.2007**
(21) Application number: 06113479.7
(22) Date of filing: 04.05.2006
(51) Int. Cl.: H05K 7/20, H01L 23/473

(54) **A cooling device and use thereof**

(71) Applicant: Bombardier Transportation GmbH, 13627 Berlin (DE)
(72) Inventor: Eriksson, Gunno, SE-734 33, Hallstahammar (SE)
(74) Representative: Olsson, Jan

(57) **Abstract**

A device for cooling at least one heat generating component (6) having a substantially flat surface (16) comprises a plate-like body (13) of a heat conducting material having a substantially flat surface (14), means (15) for attaching the body to the component with said body flat surface bearing against said component flat surface. A channel (17) extends through the body for conducting a coolant liquid therethrough. A wall (20) of the channel separating the channel and the body flat surface has a thickness with a relation to the width of the channel making it flexible. Means are arranged to feed coolant liquid through the channel with an overpressure of a level adapted to the flexibility of the channel wall (20) for making the liquid able to deform the wall so as to adapt said substantially flat body surface to said substantially flat component surface.

## Description

### TECHNICAL FIELD OF THE INVENTION AND PRIOR ART

The present invention relates to a device for cooling at least one heat generating component having a substantially flat surface, said device comprises: a plate-like body of a heat conducting material having a substantially flat surface, means for attaching said body to said component with said body flat surface bearing against said component flat surface, a channel extending through said body for conducting a coolant liquid therethrough for transferring thermal energy from said component across said flat surfaces and through said body to the coolant liquid and means for feeding said liquid through said channel.

The heat generating component to be cooled by the device may be of any type having a substantially flat surface for transfer of thermal energy to a substantially flat surface in contact therewith of said device, but for illuminating but not in any way restricting the invention a device for cooling heat generating components in the form of power semiconductor device modules will hereinafter be described. A device of this type may be used for cooling modules of one or more power semiconductor devices, such as IGBT's or thyristors, in current valves in converters, such as in AC/DC- or DC/AC-converters in a railway vehicle. For use in high power applications a plurality of such power semiconductor devices in the form of chips of one or two kinds, for example IGBT-chips and diode chips, are assembled to a so-called module on a base plate in common, and such modules are connected in parallel with each other to form one or more current valves.

It is for such power semiconductor devices important to obtain an efficient cooling, so that the temperature thereof may be kept at a level being as low as possible, since the lifetime of such a component will increase with lower operating temperatures thereof. This is particularly important when such power semiconductor devices are arranged in railway vehicles, in which the lifetime thereof should be at least as long as the lifetime of the railway vehicle, for instance 30 years, and any need of repairs or replacements would be hard to accept. This means that said power semiconductor devices have to be over-dimensioned should the capacity of such a cooling device be insufficient for otherwise keeping the operating temperature thereof sufficiently low.

It is of course important that said plate-like body of the cooling device is of a material having a high thermal conductivity, but it has been found that an even more important factor for the cooling capacity of such a cooling device is the appearance of the transition between the substantially flat component surface and the substantially flat body surface. Thus, it is very important that there is a good contact between said two surfaces, and for obtaining this a heat conducting paste is mostly introduced therebetween. However, the best such paste known today has a thermal conductivity that is about 200 times less than the thermal conductivity of aluminium, which may be a suitable material for said body.

Said base plate of a power semiconductor module serves not only as a mechanical carrier, but also as heat spreader and constitutes said plate-like body of heat conducting material. Common materials used for base plates are copper, molybdenum and Al-SiC, a composite material consisting of SiC grains bonded together by aluminium. A problem particular to Al-SiC base plates is that the SiC matrix is so hard that the substantially flat surface intended to make a close fit to a substantially flat surface of a cooling device can not be worked to the same degree of flatness as a metallic base plate. This means that such a base plate will become slightly concave in some regions, which results in a poorer contact to a perfectly flat plate-like body of a cooling device of the type defined in the introduction. In the case of a typical IGBT-module-component used in a railway vehicle this means that said substantially flat surface of the component may vary from concave to convex forming gaps of approximately 0.1 mm thickness between said flat component surface and said flat body surface, and these gaps have to be filled with a heat conductive paste at mounting.

This means that the cooling capacity of the cooling device will be lower than if said component flat surface were perfectly flat. Furthermore, the irregularities vary between different such power semiconductor device modules, so that the thermal resistance in the transition between a said module and said plate-like body of the cooling device may in fact vary 2-3 times for different said chips in the same component, and the differences may be much bigger between chips belonging to different components of the converter.

US 2005/0213304 A1 describes a cooling device of a slightly modified type, which suggests to improve the cooling capacity by spraying a coolant liquid in the form of a water film directly on said substantially flat component surface. This results in a very even cooling. However, it is for such a cooling device necessary to seal the transition between the component and the plate-like body of the cooling device by an O-ring, and O-rings may not sustain long time operation, such as for 30 years. Furthermore, problems will arise if the component has to be changed, since also the water-circuit has then to be opened, which will cause problems with water spillage and venting.

### SUMMARY OF THE INVENTION

It is an object of the present invention to provide a cooling device of the type defined in the introduction being improved in at least some aspect with respect to such cooling devices already known.

This is obtained by providing such a device in which a wall of said channel separating said channel and said body flat surface has a thickness with a relation to the width of the channel making it flexible, and by adapting said feeding means to feed said coolant liquid through said channel with an overpressure of a level adapted to the flexibility of said channel wall making the liquid able to deform the wall so as to adapt said substantially flat body surface to said substantially flat component surface.

By making said channel wall of the plate-like body of the cooling device to be placed next to said heat generating component relatively thin and feeding said coolant liquid with an appropriate overpressure an excellent adaption of the substantially flat body surface to the substantially flat component surface may be obtained. This results in practically no gaps therebetween, so that a much thinner layer of a heat conducting paste may be applied therebetween. This means that the thermal conductance of the transition between the component and said body may be substantially increased, such as 2-3 times compared with no flexibility of said wall, and since the thermal conductance of said transition is the totally determining factor of the cooling capacity of the cooling device, this cooling capacity may be increased nearly as much. Thus, this means that the temperature of the component may be kept at a lower level resulting in a longer lifetime.

Furthermore, the adaption of said substantially flat body surface to said substantially flat component surface according to the invention also results in a drastic reduction of the variation in thermal resistance between different said components and the cooling device, when a plurality of such components are cooled by the device, so that this variation in fact may be lowered from 200-300% to about 25%. This means among other things a more reliable operation of for instance a converter to which a number of such components belong or alternatively an increased power capacity of the converter with maintained reliability.

According to an embodiment of the invention said channel has substantially the same width as the width of said substantially flat surface of a said component to which said body is adapted to be attached, so that the component may be efficiently and uniformly cooled while avoiding hot spots thereon.

According to another embodiment of the invention said channel wall has a thickness being less than 10%, preferably less than 5%, of the width of the channel in the direction transversal to the extension of the channel and substantially in parallel with said flat surfaces. It has been found that this relationship between said channel wall thickness and the width of the channel is suitable for obtaining said surface adaption aimed at by means of a suitable overpressure of said coolant liquid.

According to another embodiment of the invention said channel wall has a thickness being at least 1 % of the width of the channel in the direction transversal to the extension of the channel and substantially in parallel with said flat surfaces. Such a minimum thickness with respect to the width of the channel may be advantageous for giving said wall a required strength.

According to another embodiment of the invention said channel wall has a thickness of 2-5 mm and the channel a width transversal to the extension thereof and substantially in parallel with said flat surfaces up to 150 mm, which has turned out to be a suitable relationship between channel wall thickness and channel width for some applications, such as when cooling power semiconductor devices of a converter in a railway vehicle.

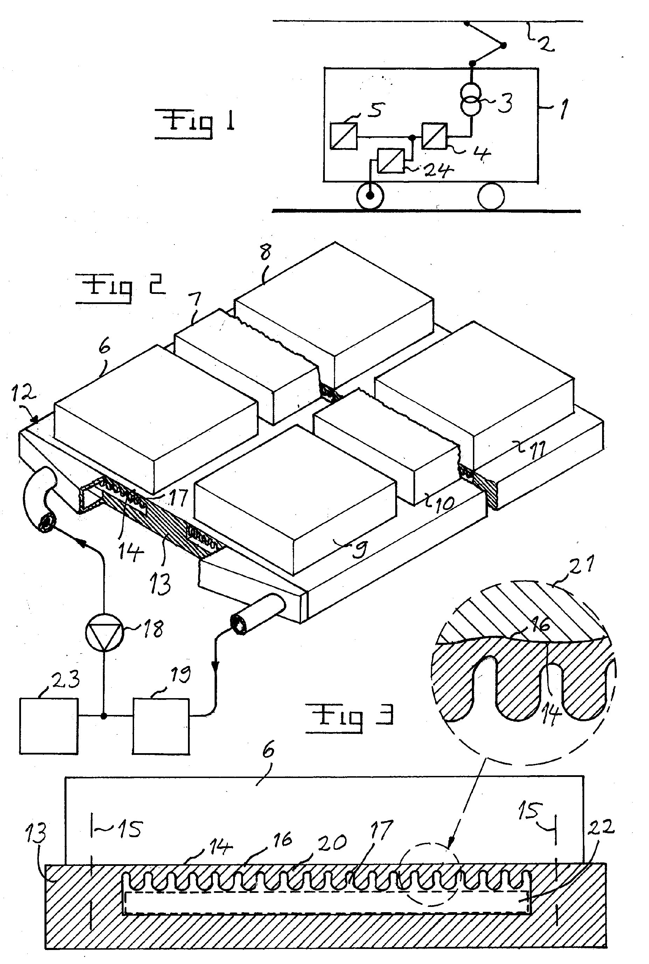

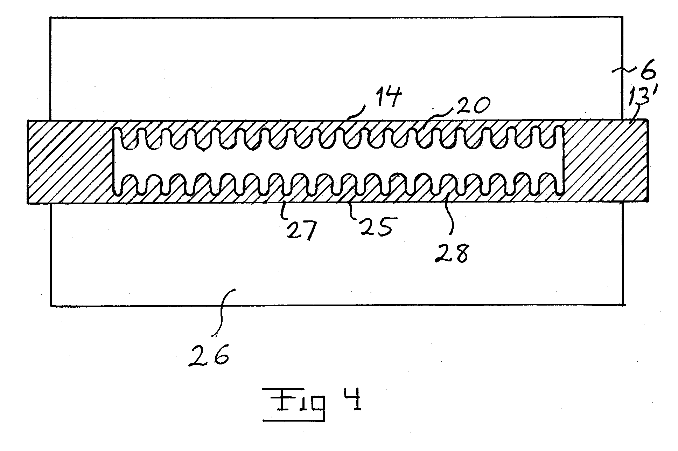

According to another embodiment of the invention said wall of the channel has a thickness varying in the direction transversal to the extension of the channel for increasing the internal surface of said channel wall. This results in an increased total surface for heat exchange between said channel wall and the coolant liquid. The thickness variation may be obtained for example by undulations of the internal surface of the channel wall as shown in fig 3 and fig 4 of this disclosure. It is pointed out that the thickness referred to above, such as in the relation to the channel width, means the thickness where it has its lowest value, such as when the thickness varies between 2 and 6 mm and the channel width is 100 mm, said relationship is defined to be 2%.

According to another embodiment of the invention said body is made of aluminium or copper or an aluminium or copper alloy, and according to a still further embodiment of the invention said body is made of extruded aluminium or aluminium alloy. Aluminium and aluminium alloys are suited to be used for the possibility to use the extrusion technique for producing said body. Copper is also an interesting material, since the thermal conductivity thereof is even higher than for aluminium.

According to another embodiment of the invention the device comprises at least one sheet-like member introducible into said channel for reducing the cross-section thereof and thereby increasing the flow velocity of said coolant liquid through the channel. This results in an option to increase the cooling capacity in applications where the coolant liquid allows this.

According to another embodiment of the invention said sheet-like member varies in thickness along the longitudinal extension of said channel. This is particularly interesting when said channel is adapted to extend to pass a said plurality of components, since said variation of the thickness of the sheet-like member may then be adapted to achieve a higher flow velocity of said coolant liquid at those components expected to otherwise become the hottest.

According to another embodiment of the invention said plate-like body is produced with a same die as such plate-like bodies of similar devices comprising said sheet-like member, and said sheet-like member is omitted in this device. The pressure drop in said channel may in this way be restricted and an overheating when cooling particularly hot components may by this be avoided.

According to another embodiment of the invention said plate-like body has a second substantially flat surface opposite to said substantially flat surface first mentioned, the device has means for attaching said body to a further said at least one heat generating component with said second body flat surface bearing against said further component flat surface, a second wall of said channel separating said channel and said second body surface has a thickness with a relation to the width of the channel making it flexible, and said level of overpressure of said coolant liquid is adapted to the flexibility of said second channel wall making the liquid able to deform said second channel wall so as to adapt said second substantially flat body surface to said further component substantially flat surface.

According to another embodiment of the invention said feeding means is adapted to feed said liquid through said channel with an overpressure exceeding 0.5 bar. It has been found that such an overpressure, which is easy to obtain, is in most cases sufficient for obtaining said surface adaption when appropriately dimensioning said channel wall. However, the overpressure may be increased by a factor 2-3 for increasing the reliability of a perfect adaption of the substantially flat body surface against the substantially flat component surface in question.

According to another embodiment of the invention said feeding means comprises a pump adapted to provide an overpressure exceeding 0.3 bar, preferably about 0.5 bar to said liquid. According to another embodiment said feeding means comprises an expansion vessel maintaining the overpressure of said liquid, preferably at 0.5-1.5 bar. The overpressures from the pump and the expansion vessel may be adapted so that they result in a level of the total overpressure aimed at.

According to another embodiment of the invention said channel wall has sufficient strength to withstand the overpressure also when said component is separated from said body.

According to another embodiment of the invention said feeding means is adapted to feed water as said coolant liquid, which is suitable thanks to the availability and low cost of water. According to a further embodiment of the invention said feeding means is adapted to feed a mixture of water and an anti-freeze agent as said coolant liquid, which ensures safe operation of the device also at lower temperatures.

According to another embodiment of the invention said attaching means comprises screws or bolts. The body of the cooling device may conveniently be attached and tightened to said heat generating component by such attaching means, and they also allow a separating of the heat generating component from the cooling device should that be necessary.

According to another embodiment of the invention the device comprises a heat conducting paste on said substantially flat body surface for improving the thermal conductivity of a transition between said body and a component to be cooled. Such a paste may improve said thermal conductivity even if said adaption of the substantially flat body surface to the substantially flat component surface is very good, but in such a case the paste layer may be very thin.

According to another embodiment of the invention the device is adapted to cool at least one heat generating component in the form of a module of one or more power semiconductor devices, such as an IGBT, thyristor, diode etc, which is a preferred application of a device according to the invention.

According to another embodiment of the invention the device is adapted to cool at least one said component, such as an IGBT-and/or a diode-module, in a current valve of a converter, such as an AC/DC- or DC/AC-converter in a railway vehicle.

The invention also relates to a use of a device according to the invention for cooling at least one heat generating component, such as an IGBT- and/or a diode-module, in a current valve of a converter, such as an AC/DC- or DC/AC-converter in a railway vehicle. Such a use is particularly advantageous, since the dimensioning of the semiconductor devices and their cooling in railway vehicle propulsion converters often is decised not only by the maximum dissipation causing overheating and instant failure but also by the long time fatigue at soldered joints in case of large magnitude thermal cycling.

The invention also relates to a use of a device according to the invention for cooling at least two identical heat generating components, such as IGBT-modules or diode modules, electrically connected in parallel or in series and together constituting the current valve of a converter, such a use is particularly advantageous since the low variation of the heat conductance from heat generating component to cooling liquid results in a smaller spread between the temperatures of the components thus connected in parallel or in series, thereby improving the matching of their electrical characteristics, especially the static and dynamic current sharing for parallel connected components and the static and dynamic voltage sharing for series connected components.

Further advantages as well as advantageous features of the invention will appear from the following description.

### BRIEF DESCRIPTION OF THE DRAWINGS

With reference to the appended drawings, below follows a specific description of embodiments of the invention cited as examples.

In the drawings:
- Fig 1: is a very schematic view illustrating where a cooling device according to the invention may be used,
- Fig 2: is a partially sectioned and simplified view of a cooling device according to a first embodiment of the invention in use for cooling power semiconductor devices in the form of IGBT's in a converter,
- Fig 3: is a cross-section view of the body with the channel for coolant liquid of a cooling device according to a second embodiment of the invention with a detail shown in larger scale, and
- Fig 4: is a cross-section view corresponding to fig 3 of a body with a channel for coolant liquid of a cooling device according to a third embodiment of the invention.

### DETAILED DESCRIPTION OF EMBODIMENTS OF THE INVENTION

Fig 1 schematically shows a typical use of a cooling device according to the present invention. It is shown how a railway vehicle 1 receives electrical energy through a contact line 2 with for instance a one-phase alternating voltage of 16 kV. This voltage is transformed in a transformer 3 and converted in a AC/DC-converter 4 into a direct voltage, and this direct voltage is in a further DC/AC-converter 5 converted into an alternating voltage to be used for lighting and other equipment onboard the vehicle. The direct voltage from the AC/DC-converter 4 is also converted in a further DC/AC-converter 24 to an alternating voltage driving the motor of the vehicle. Said converters 4, 5 include a number of current valves each having an IGBT and a diode connected in anti-parallel therewith and assembled on a common base plate, the backside of which is substantially flat and intended for attaching to a cooling device. The IGBT's are controlled for obtaining said voltage conversion through a Pulse Width Modulation pattern. The power to be handled by the IGBT's is particularly high when the vehicle is accelerating and heat power of approximately 3 kW may then be generated in each IGBT. This power results in a generation of heat which would destroy said IGBT's if no active cooling thereof would take place.

Fig 2 schematically shows a number of such heat generating components 6-11 1 attached to a common cooling device 12 according to the present invention. The heat generating components attached to said cooling device will generally be those dissipating most of the losses of the converter, for example the IGBT-modules constituting the current valves. This cooling device has a plate-like body 13 of a heat conducting material, for example extruded aluminium or copper, having a substantially flat surface 14. Reference is now also made to Fig 3. Means in the form of bolts, schematically indicated at 15 in Fig 3, are arranged and tightened for attaching the body 13 to each component 6-11 with the flat body surface 14 bearing against a substantially flat surface 16 of the component, which may belong to a base plate of the component of for instance AlSiC.

A channel 17 extends through the body 13 for conducting a coolant liquid, such as water or a mixture of water and an anti-freeze agent, therethrough for transferring thermal energy from the components 6-11 across said flat surfaces 14, 16 and through the body 13 to the coolant liquid. Due to the flow of the cooling liquid entering the channel 17 near the heat generating component 6 and passing the other heat generating components 7, 8, 11 and 10 one after the other until exiting the channel after passing the heat generating component 9 the cooling liquid will have a higher temperature and a lower pressure near the heat generating component 9 than near the heat generating component 6.

It is illustrated in Fig 2 how the cooling device comprises means 18 in the form of a pump, for feeding the liquid through the channel 17. This is done in a loop including a heat exchanger 19 or other means for cooling said liquid after passing through the channel 17 before being fed through the pump 18 into the channel again.

It is shown in Fig 3 that the wall 20 of the channel 17 separating the channel and the body flat surface 14 is thin, and it has a thickness with a relation to the width of the channel making it flexible. This means in the present case that the width of the channel is 110 mm, whereas the thickness of said wall at the thinnest location is 2 mm. However, the wall has a thickness varying in the direction transversal to the extension of the channel and substantially in parallel with said flat surfaces for increasing the internal surface of the channel wall, and the thickness thereof at the thickest locations is about 6.5 mm. The channel has a height varying between 6.5 and 11 mm depending upon the variation of the thickness of the wall 20.

The pump 18 is adapted to feed the coolant liquid through the channel 17 with an overpressure of a level adapted to the flexibility of the channel wall 20 making the liquid able to deform the wall so as to adapt the substantially flat body surface 14 to the substantially flat component surface 16 as illustrated in en exaggerated way in larger scale at 21 in Fig 3. This means that the thermal resistance of the transition between the component and the body of the cooling device may be lowered substantially.

It is shown in Fig 3 how a sheet-like member 22, here with a thickness of 6 mm, may be introduced into the channel 17 for reducing the cross-section thereof and thereby increasing the flow velocity of the coolant liquid through the channel, so that the cooling capacity may be increased. This may be done if the coolant liquid has to only pass one or few said components before being cooled or discharged, since in any way in the reality nearly only the part of the liquid passing close to the wall 20 will participate in the cooling. However, in the case shown in Fig 2, in which the body 13 is adapted to receive many components and the channel is adapted to extend to pass all these components with the same liquid without intermediate cooling thereof, there is a risk that this liquid gets too hot should a sheet-like member 22 be used. The sheet-like member 22 may in this case be omitted for reducing the temperature increase of the liquid when passing the components to be cooled.

The cooling device according to the invention may also comprise an expansion vessel 23 for providing said liquid with an overpressure, preferably of 0.5-1.5 bar.

A device according to a third embodiment of the invention is schematically shown in fig 4. This cooling device differs from that shown in fig 3 by the fact that said plate-like body 13' has a second substantially flat surface 25 opposite to said substantially flat surface 14. The device has means not shown for attaching said body 13' to a further said at least one heat generating component 26 with said second body flat surface bearing against said further component flat surface 27. A second wall 28 of said channel 17 separating said channel 17 and said second body surface 25 has a thickness with a relation to the width of the channel making it flexible, and the level of overpressure of said coolant liquid is adapted to the flexibility of this second channel wall making the liquid able to deform this wall so as to adapt said second substantially flat body surface 25 to said further component substantially flat surface 27. This embodiment enables an efficient cooling of a certain number of heat generating components with a low demand of space.

The invention is of course not in any way restricted to the embodiments described above, but many possibilities to modifications thereof would be apparent to a person with ordinary skill in the art without departing from the basic idea of the invention as defined in the appended claims.

It is pointed out that the cooling device according to the invention may be used for all cases where a heat generating component having a substantially flat surface or being carried by a base plate of a flat surface is attached, such as screwed, onto a substantially flat cooling device body and there is a real contact pressure only around the attachment means, such as the bolts.

## Claims

1. A device for cooling at least one heat generating component (6-11) having a substantially flat surface (16), said device comprises:
• a plate-like body (13) of a heat conducting material having a substantially flat surface (14),
• means (15) for attaching said body to said component with said body flat surface bearing against said component flat surface,
• a channel (17) extending through said body for conducting a coolant liquid therethrough for transferring thermal energy from said component across said flat surfaces and through said body to the coolant liquid, and
• means (18) for feeding said liquid through said channel,
**characterized in**
• **that** a wall (20) of said channel separating said channel (17)and said body flat surface (14) has a thickness with a relation to the width of the channel making it flexible,
• and **that** said feeding means (18) is adapted to feed said coolant liquid through said channel with an overpressure of a level adapted to the flexibility of said channel wall making the liquid able to deform the wall so as to adapt said substantially flat body surface to said substantially flat component surface.

2. A device according to claim 1, **characterized in that** said channel (17) has substantially the same width as the width of said substantially flat surface (16) of a said component to which said body (13) is adapted to be attached.

3. A device according to claim 1 or 2, **characterized in that** said channel wall (20) has a thickness being less than 10%, preferably less than 5%, of the width of the channel (17) in the direction transversal to the extension of the channel and substantially in parallel with said flat surfaces (14, 16).

4. A device according to claim 3, **characterized in that** said channel wall (20) has a thickness being at least 1 % of the width of the channel (17) in the direction transversal to the extension of the channel and substantially in parallel with said flat surfaces (14, 16).

5. A device according to any of the preceding claims, **characterized in that** said channel wall (20) has a thickness of 2-5 mm and the channel a width transversal to the extension thereof and substantially in parallel with said flat surfaces (14, 16) of up to 150 mm.

6. A device according to any of the preceding claims, **characterized in that** said channel wall (20) has a thickness varying in the direction transversal to the extension of the channel (17) for increasing the internal surface of said channel wall.

7. A device according to any of the preceding claims, **characterized in that** said body (13) is made of aluminium or copper or an aluminium or copper alloy.

8. A device according to any of the preceding claims, **characterized in that** said body (13) is made of extruded aluminium or aluminium alloy.

9. A device according to any of the preceding claims, **characterized in that** it comprises at least one sheet-like member (22) introducible into said channel (17) for reducing the cross-section thereof and thereby increasing the flow velocity of said coolant liquid through the channel.

10. A device according to any of the preceding claims, **characterized in that** said body (13) is adapted to receive a plurality of said heat generating components (6-11) on a substantially flat said body surface (14), and that said channel is elongated and adapted to extend to pass said plurality of components.

11. A device according to claim 9, **characterized in that** said sheet-like member (22) varies in thickness along the extension of said channel (17).

12. A device according to claim 10 and 11, **characterized in that** the variation of the thickness of said sheet-like member (22) is adapted to achieve a higher flow velocity of said coolant liquid at those components expected to otherwise become the hottest.

13. A device according to claim 8 and any of claims 9-11, **characterized in that** said plate-like body (13) is produced with a same die as such plate-like bodies (13) of similar devices comprising said sheet-like member (22), and that said sheet-like member (22) is omitted in this device.

14. A device according to any of the preceding claims, **characterized in that** said plate-like body (13) has a substantially flat surface opposite to said substantially flat surface (14) first mentioned, that the device has means for attaching said body to a further said at least one heat generating component with said second body flat surface bearing against said further component flat surface, that at second wall of said channel (17) separating said channel (17) and said second body surface has a thickness with the relation to the width of the channel making it flexible, and that said level of overpressure of said coolant liquid is adapted to the flexibility of said second channel wall making the liquid able to deform said second channel wall so as to adapt said second substantially body surface to said further component substantially flat surface.

15. A device according to any of the preceding claims, **characterized in that** said feeding means (18) is adapted to feed said liquid through said channel with an overpressure exceeding 0.5 bar.

16. A device according to claim 15, **characterized in that** said feeding means comprises a pump (18) adapted to provide an overpressure exceeding 0.3 bar, preferably of about 0.5 bar, to said liquid.

17. A device according to claim 15 or 16, **characterized in that** said feeding means comprises an expansion vessel maintaining the overpressure of said liquid, preferably at 0.5-1.5 bar.

18. A device according to any of claims 15-17, **characterized in that** said channel wall (20) has sufficient strength to withstand the overpressure also when said component is separated from said body (13).

19. A device according to any of the preceding claims, **characterized in that** said feeding means (18) is adapted to feed water as said coolant liquid.

20. A device according to any of claims 1-18, **characterized in that** said feeding means (18) is adapted to feed a mixture of water and an anti-freeze agent as said coolant liquid.

21. A device according to any of the preceding claims, **characterized in that** said attaching means (15) comprises screws or bolts.

22. A device according to any of the preceding claims, **characterized in that** it comprises a heat conducting paste on said substantially flat body surface for improving the thermal conductivity of a transition between said body and a component to be cooled.

23. A device according to any of the preceding claims, **characterized in that** it is adapted to cool at least one heat generating component (6-11) in the form of a module of one or more power semiconductor devices, such as an IGBT, thyristor, diode etc.

24. A device according to claim 23, **characterized in that** it is adapted to cool at least one said component (6-11), such as an IGBT- and/or a diode-module, in a current valve of a converter, such as an AC/DC- or DC/AC-converter in a railway vehicle.

25. Use of a device according to any of claims 1-23 for cooling at least one heat generating component in the form of a module of one or more power semiconductor devices, such as an IGBT, thyristor, diode etc.

26. Use of a device according to any of claims 1-23 for cooling at least one said component, such as an IGBT- and/or a diode-module, in a current valve of a converter, such as an AC/DC- or DC/AC-converter in a railway vehicle.

27. Use of a device according to any of claims 1-23 for cooling at least two substantially identical components, such as IGBT modules or diode modules, electrically connected in parallel and constituting a current valve of a converter, such as an AC/DC, DC/DC- or DC/AC-converter.

28. Use of a device according to any of claims 1-23 for cooling at least two substantially identical components, such as IGBT-modules or diode modules, electrically connected in series and constituting a current valve of a converter, such as an AC/DC-, DC/DC- or DC/AC-converter.
